# EUROPÄISCHE PATENTSCHRIFT

(11) **EP 1 146 393 B1**
(45) Veröffentlichungstag und Bekanntmachung des Hinweises auf die Patenterteilung: **02.11.2016**
(21) Anmeldenummer: 01107628.8
(22) Anmeldetag: 27.03.2001
(51) Int. Cl.: G03F 1/00, G03F 1/70

(54) **Verfahren zur Herstellung von Masken für die Fertigung von Halbleiterstrukturen**
Process for producing photomasks for making semi-conductor patterns
Procédé pour réaliser des photomasques pour la production des structures sur semi-conducteurs

(30) Priorität: 10.04.2000 DE 10017767
(43) Veröffentlichungstag der Anmeldung: 17.10.2001
(73) Patentinhaber: Polaris Innovations Limited, Dublin 2 (IE)
(72) Erfinder: Fischer, Werner, 91560 Heilsbronn (DE); Ludwig, Burkhard, 81379 München (DE); Meyer, Dirk, 85551 Kirchheim (DE); Thiele, Jörg, 80636 München (DE)
(74) Vertreter: Epping - Hermann - Fischer

(56) Entgegenhaltungen:
- EP-A- 0 685 804
- US-A- 5 801 954

## Beschreibung

Die vorliegende Erfindung betrifft ein Verfahren zur Herstellung von Masken für die Fertigung von Halbleiterstrukturen.

Auf dem Gebiet der Fertigung von Halbleiterstrukturen, beispielsweise bei der Herstellung von integrierten Schaltungen auf der Basis von Halbleiterscheiben, werden auf den Halbleiterscheiben eine Vielzahl von einzelnen Bereichen, z.B. Leiterbahnen, unterteilt. Diese Strukturierung erfolgt mit Hilfe der lithographischen Technik, bei der insbesondere Masken bzw. Maskenstrukturen erzeugt werden, die zur Herstellung von Halbleiterstrukturen der integrierten Schaltung in darauffolgenden Prozeßschritten dienen. Bei der Herstellung von Masken bzw. von Maskenstrukturen besteht ein Hauptziel insbesondere darin, die Vielzahl der Strukturen auf der Halbleiterscheibe maßgetreu, lagerichtig und defektfrei zu erzeugen.

Die stetige Verkleinerung der Dimensionen bei der Herstellung von integrierten Schaltungen verlangt dabei zunehmend nach sogenannten Hilfsstrukturen oder Modifikationen der generierten Maskenstrukturen beim Entwurf der jeweiligen Maske, damit die Herstellbarkeit der herzustellenden Maske gewährleistet ist. Hilfsstrukturen dienen beispielsweise zur Planarisierung. Sie sind elektrisch nicht wirksam und erlauben dabei gewisse geometrische Freiheiten beim Entwurf der entsprechenden Maskenstruktur. Beispiele für technologische Vorteile, die man durch Modifikation von Maskenstrukturen erreicht, sind Verbesserung von Abbildungseigenschaften, Prozeßfenstervergrößerung (Prozeßfenster als allgemeiner Begriff für erlaubte Streuung von Prozeßparametern), Verbesserung der Planarisierungseigenschaften, Steigerung der Ausbeute oder robusteres Design.

Bei Verfahren zur Herstellung von Masken erfolgt die Herstellung einer Maske üblicherweise anhand von generierten Layoutdaten, die Information zum Festlegen eines Maskenlayouts enthalten. Das Maskenlayout weist dabei einzelne geometrische Strukturelemente auf, die die Maskenstrukturen repräsentieren. Häufig ist bei der Generierung der Layoutdaten die Erzeugung mehrerer Maskenebenen notwendig, um den Fertigungsprozeß zu optimieren.

In der US-A-5 801 954 ist ein Verfahren zur Erzeugung eines Maskenlayouts beschrieben, bei dem ein Muster einer Phasenschiebermaske anhand des simulierten Ergebnisses im Falle einer lithographischen Projektion so lange verändert wird, bis zum einen das gewünschte Muster auf dem Wafer erzeugt wird und zum anderen das gewünschte Muster keinerlei Design-Anforderungen auf dem Wafer verletzt. Dazu wird eine Verifikation des simulierten Musters durchgeführt.

In der EP-A-0 685 804 ist ein Verfahren zur Plazierung einer Vielzahl von Schaltungsblöcken beschrieben, die bestimmten Randbedingungen wie beispielsweise bezüglich ihrer Abstände genügen müssen. Dazu werden die Randbedingungen in Form von Gleichung oder Ungleichungen parametrisiert, um die Einhaltung während der automatisierten Plazierung gewährleisten zu können.

Mit zunehmender Komplexität des Maskenlayouts bzw. der Layoutdaten einer herzustellenden Maske und bei der Verkleinerung der Dimensionen wird es schwieriger und zeitaufwendiger, Modifikationen der Maskenstrukturen bzw. der Layoutdaten bei der Maskengenerierung beispielsweise manuell durchzuführen, so daß die Herstellbarkeit der Maske gewährleistet ist. Dabei sollen Generierungsfehler von Layoutdaten beseitigt werden.

Dazu ist es erforderlich, eine technologieabhängige Optimierung der Layoutdaten vorzunehmen.

Die Aufgabe der vorliegenden Erfindung ist es, ein Verfahren zur Herstellung von Masken für die Fertigung von Halbleiterstrukturen anzugeben, bei dem Fehler im Maskenlayout, die die Herstellbarkeit der Maske oder deren Brauchbarkeit zur Fertigung von Halbleiterstrukturen beeinträchtigen könnten, durch eine Modifikation von erzeugten Layoutdaten vermieden werden, wobei das Verfahren eine verhältnismäßig schnelle Modifikation der Layoutdaten und deren technologieabhängige Optimierung ermöglichen soll.

Diese Aufgabe wird gelöst durch ein Verfahren zur Herstellung von Masken für die Fertigung von Halbleiterstrukturen, wobei das Verfahren mittels einer Datenverarbeitungseinrichtung durchgeführt wird und die folgenden Schritte umfasst:
- es werden Layoutdaten erzeugt, die Informationen zum Festlegen eines Maskenlayouts für eine herzustellende Maske enthalten, wobei das Maskenlayout geometrische Strukturelemente aufweist,
- es werden geometrische Design-Anforderungen für einzelne Strukturelemente der Strukturelemente und für die Anordnung dieser einzelnen Strukturelemente im Maskenlayout festgelegt,
- es werden die Layoutdaten dahingehend überprüft, ob die geometrischen Design-Anforderungen für die einzelnen Struktu relemente und für deren Anordnung im Maskenlayout erfüllt sind,
- im Falle der Verletzung von Design-Anforderungen werden die entsprechenden Fehlerorte im Maskenlayout anhand der Layoutdaten lokalisiert,
- es werden weitere Layoutdaten erzeugt, die Information zum Festlegen von Korrekturfiguren zur Korrektur der jeweiligen Fehlerorte enthalten,
- es werden die Layoutdaten mit den weiteren Layoutdaten verknüpft, so daß die Layoutdaten modifiziert werden.

Zur Durchführung des Verfahrens wird ausgenutzt, daß sich die Strukturelemente und deren Design-Anforderungen durch sogenannte situationsbeschreibende Attribute charakterisieren lassen. So zeichnen sich z.B. isolierte Linien durch das Attribut aus, daß in einem gewissen Abstand keine benachbarten Strukturen sind. Strukturen für bestimmte Maskenebenen zur Verbesserung der Planarisierungseigenschaften werden durch das Attribut einer genügend großen Struktur auf der zu planarisierenden Maskenebene beschrieben. Solche Attribute lassen sich mit einer Software zur physikalischen Verifikation (beispielsweise "Vampire") finden und klassifizieren. Diese klassifizierten Attribute werden auch als sogenannte "Marker" bezeichnet. Diese Marker werden nun verwendet, um die Layoutdaten situationsabhängig zu modifizieren.

Wie eingangs beschreiben, entstehen bei der Generierung von Layoutdaten einer herzustellenden Maske aufgrund immer höherer Anforderungen bezüglich der Herstellung von integrierten Schaltungen Generierungsfehler, die festgelegte Design-Anforderungen verletzen. Solche Generierungsfehler sind beispielsweise Abstands- oder Weitenverletzungen der Strukturelemente des Maskenlayouts. Sind die entsprechenden Fehlerorte im Maskenlayout lokalisiert, werden sie durch Überlagerung von Korrekturfiguren, die eine Beseitigung der Verletzung der Design-Anforderungen bewirken sollen, korrigiert. In diesem Zusammenhang kann man auch von einer Reparatur eines Datenzustandes beim Maskenentwurf durch sogenannte Reparaturfiguren sprechen.

Es werden also die weiteren Layoutdaten, die die Information zum Festlegen der Korrekturfiguren enthalten, mit Rücksicht auf die Maskenanforderungen erzeugt. Die weiteren Layoutdaten werden beispielsweise durch Modifikation der Layoutdaten der jeweiligen Fehlerorte erzeugt. Werden Layoutdaten einer herzustellenden Maske für eine oder mehrere Maskenebenen erzeugt, so kann das Verfahren vorteilhaft für jede der Maskenebenen durchgeführt werden.

Das erfindungsgemäße Verfahren erlaubt es, die bei einer Generierung der Layoutdaten einer herzustellenden Maske entstehenden Fehler vollständig, vollautomatisch und gemäß technologisch vorgegebener Optimierungskriterien zu beheben. Das Verfahren kann dabei relativ einfach in existierende Standard-Entwurfsabläufe (Design-Flows) integriert werden. Es können verschiedene technologische Randbedingungen für die Generierung der Layoutdaten vorgegeben werden, so daß eine gemäß diesen Randbedingungen optimierte Lösung gefunden werden kann. Das Verfahren kann dabei so gestaltet werden, daß manuelle Nacharbeit entfallen kann, wodurch das Verfahren insgesamt beschleunigt wird.

Die Generierungsfehler können durch Hinzufügen von Korrekturfiguren an den entsprechenden Fehlerorten oder durch Zurückschneiden der Strukturelemente an den Fehlerorten eliminiert werden. Im ersteren Fall werden die Layoutdaten an den jeweiligen Fehlerorten mit den weiteren Layoutdaten zum Festlegen der Korrekturfiguren additiv verknüpft. Im zweiten Fall werden die Layoutdaten der jeweiligen Fehlerorte mit den weiteren Layoutdaten subtraktiv verknüpft (subtraktive Korrekturfiguren).

Durch das Hinzufügen von Korrekturfiguren kann das ursprüngliche Maskenlayout bzw. deren Strukturelemente und deren Anordnung verändert werden. Wie eingangs beschrieben, bestehen bei der Fertigung von Hilfsstrukturen einer integrierten Schaltung, die in der integrierten Schaltung elektrisch nicht wirksam sind, gewisse geometrische Freiheiten bei der Gestaltung der Strukturelemente bzw. bei deren Anordnung. Das erfindungsgemäße Verfahren ist daher vorteilhaft einsetzbar zur Herstellung von Masken, die zur Fertigung von Hilfsstrukturen einer integrierten Schaltung dienen.

Wird das Verfahren angewandt zur Herstellung von Masken zur Fertigung von Halbleiterstrukturen einer integrierten Schaltung, die elektrisch wirksam sind, so ist bei der Durchführung des Verfahrens darauf zu achten, daß die sogenannten Connectivity-Beziehungen zwischen den Strukturelementen der Maske bei der Modifikation der Layoutdaten nicht verändert werden.

Um ein wiederholtes Korrigieren bzw. Reparieren identischer Konfigurationen im Hinblick auf Laufzeit und Speicher-Ressourcen zu vermeiden, ist es vorteilhaft, eine vorhandene hierarchische Struktur der Layoutdaten auszunutzen. Dazu werden anhand des Verfahrens die Layoutdaten nacheinander gemäß ihrer hierarchischen Struktur unter Berücksichtigung des jeweiligen geometrischen Kontexts modifiziert. Dabei wird berücksichtigt, daß sich einzelne Strukturelemente bzw. deren Anordnung im Maskenlayout regelmäßig wiederholen und sich dabei in einer hierarchischen Struktur zu einer übergeordneten Funktionsgruppe zusammensetzen können. Ist eine Korrektur einer derartigen Funktionsgruppe auf einer bestimmten Hierarchieebene vorgenommen, so ist es vorteilhaft, diese direkt auf andere vergleichbare Funktionsgruppen der gleichen oder höheren Hierarchieebene anzuwenden, unter Berücksichtigung des geometrischen Kontexts der jeweiligen Funktionsgruppe.

Um ein wiederholtes aufwendiges Lösen identischer Generierungsfehler oder Optimierungsprobleme zu vermeiden, ist es vorteilhaft, die geometrischen Konfigurationen mit dazugehörigen Korrekturfiguren in einer Datenbibliothek abzulegen und die Ergebnisse wiederzuverwenden. Zu diesem Zweck werden die Layoutdaten einer herzustellenden Maske und die jeweils zugehörigen weiteren Layoutdaten zum Festlegen zugehöriger Korrekturfiguren in einer Datenbibliothek gespeichert.

In einer Ausgestaltung des erfindungsgemäßen Verfahrens werden etwaige Fehler, die bei der Modifikation der Layoutdaten entstehen (sogenannte Sekundärfehler) iterativ beseitigt. Dazu werden die Schritte der Überprüfung der Layoutdaten, der Lokalisierung der Fehlerorte, der Erzeugung der weiteren Layoutdaten und der Verknüpfung der Layoutdaten mit den weiteren Layoutdaten solange nacheinander durchgeführt, bis keine Design-Anforderungen mehr verletzt werden. Vorhandene Sekundärfehler werden also durch eine wiederholte Anwendung der Prüf- und Modifikationsschritte beseitigt.

In einer weiteren Ausführungsform des erfindungsgemäßen Verfahrens sind die Korrekturfiguren parametrisierbar. Dazu werden die weiteren Layoutdaten derart erzeugt, daß die Kanten der Korrekturfiguren parametrisiert sind. Aus dem geometrischen Kontext der parametrisierten Kanten werden Ungleichungen für die Kanten der Korrekturfiguren aufgestellt, die die potentiellen Lagen der Kanten beschreiben. Es wird ein Optimierungskriterium bezüglich den geometrischen Anforderungen der Korrekturfiguren aufgestellt. Zur Bestimmung der jeweiligen Lagen der Kanten wird ein mathematisches Optimierungsverfahren angewandt, so daß jeweils die aufgestellten Ungleichungen und das Optimierungskriterium erfüllt sind. Dadurch sind die Korrekturfiguren durch die bestimmten Lagen der Kanten festgelegt. Mit dieser Ausführungsform des Verfahrens können die Korrekturfiguren kontextabhängig und nach dem Optimierungskriterium genau in der benötigten Form erzeugt werden. Somit entstehen keine Sekundärfehler.

Weitere vorteilhafte Aus- und Weiterbildungen sind in Unteransprüchen gekennzeichnet.

Die Erfindung wird nachfolgend anhand der in der Zeichnung dargestellten Figuren, die Ausführungsbeispiele darstellen, näher erläutert. Es zeigen:
- Figur 1: ein Flußdiagramm einer Ausführungsform des erfindungsgemäßen Verfahrens,
- Figur 2: ein geometrisches Beispiel zur Durchführung des Verfahrens gemäß Figur 1,
- Figur 3: ein Flußdiagramm einer weiteren Ausführungsform des erfindungsgemäßen Verfahrens,
- Figur 4: ein geometrisches Beispiel zur Durchführung des Verfahrens gemäß Figur 3.

Für die im folgenden dargestellten Ausführungsbeispiele sollen zur Verdeutlichung nur Generierungsfehler mit Abstandsverletzungen der einzelnen Strukturelemente auf der herzustellenden Maske betrachtet werden. Es werden zwei Verfahren ausgeführt, mit denen Abstandsverletzungen durch Hinzufügen von Korrekturfiguren beseitigt werden. Die Verfahren können analog zur gleichzeitigen Beseitigung von Weitenverletzungen und zur Beseitigung von Verletzungen anderer geometrischer Design-Anforderungen erweitert werden. Analog können beispielsweise Abstands- und Weitenverletzungen auch durch ein Zurückschneiden von Strukturelementen (subtraktive Korrekturfiguren) eliminiert werden.

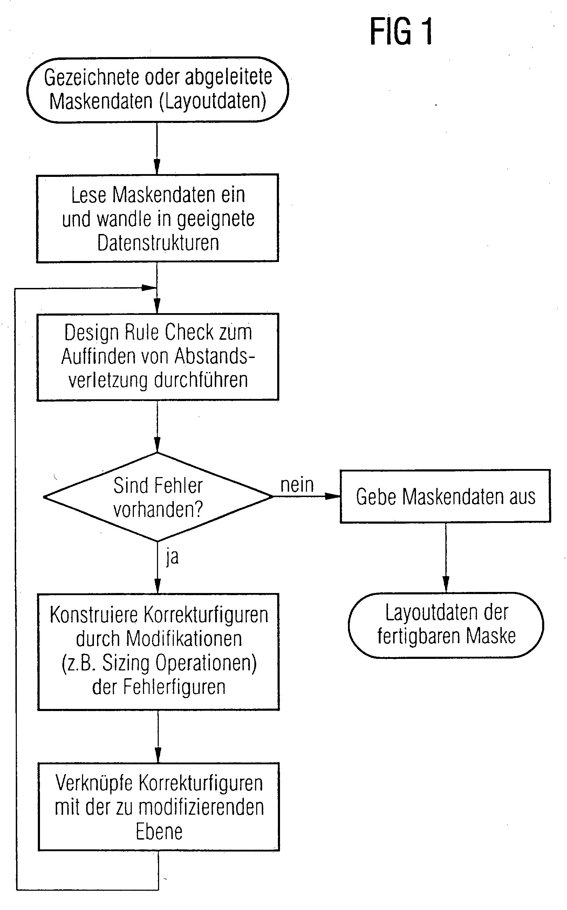

In dem Ausführungsbeispiel nach Figur 1 werden Generierungsfehler in der Form von Abstandsverletzungen durch wiederholte Anwendung von Prüf- und Modifikationsschritten beseitigt. Zur Modifikation der Layoutdaten der jeweiligen Fehlerorte (Fehlerfiguren) sind einzelne Operationen wie sogenanntes Sizing oder eine Folge von geometrischen Operationen zweckmäßig. Dabei ist es vorteilhaft, den geometrischen Kontext der jeweiligen Fehlerfigur soweit wie möglich zu beachten. Beispielsweise werden an der jeweiligen Fehlerfigur anliegende Kanten bei der Modifikation der jeweiligen Fehlerfigur berücksichtigt.

Wie Figur 1 zu entnehmen, werden zunächst Layoutdaten einer herzustellenden Maske in Form von gezeichneten oder abgeleiteten Maskendaten erzeugt. Diese werden zur Weiterverarbeitung in eine Verarbeitungseinrichtung eingelesen und in geeignete Datenstrukturen umgewandelt. Außerdem werden geometrische Design-Anforderungen für die einzelnen Strukturelemente des Maskenlayouts und deren Anordnung festgelegt. Im Fortgang des Verfahrens werden die eingelesenen Masken dahingehend überprüft, ob die geometrischen Design-Anforderungen für die einzelnen Strukturelemente und deren Anordnung erfüllt sind. Es wird also ein sogenannter Design-Rule-Check beispielsweise mittels einer Verifikationssoftware durchgeführt zum Auffinden von Abstandsverletzungen. Im Falle der Verletzung von Design-Anforderungen werden die entsprechenden Fehlerorte im Maskenlayout anhand der Layoutdaten lokalisiert. Es werden dann weitere Layoutdaten zum Festlegen von Korrekturfiguren erzeugt. Diese können beispielsweise durch Modifikationen, wie z.B. Sizing-Operationen der Fehlerfiguren konstruiert werden. Anschließend werden die Layoutdaten der zu modifizierenden Ebene mit den weiteren Layoutdaten bzw. den Korrekturfiguren verknüpft, so daß die Layoutdaten modifiziert werden. Gemäß Figur 1 werden die genannten Schritte nacheinander so lange durchgeführt, bis keine Design-Anforderungen mehr verletzt werden. Durch Ausgabe der so erzeugten Maskendaten liegen nunmehr die Layoutdaten der fertigbaren Maske vor.

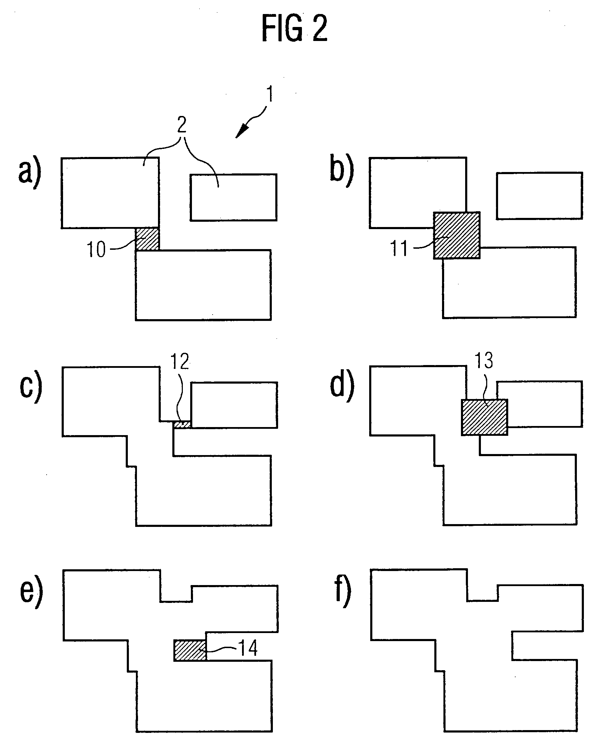

In Figur 2a ist eine Konfiguration eines Maskenlayouts 1 mit Strukturelementen 2 dargestellt, die eine Abstandsverletzung in Form des Fehlerorts bzw. der Fehlerfigur 10 aufweisen. Wie in Figur 2b dargestellt, wird die Fehlerfigur 10 modifiziert, so daß die Korrekturfigur 11 erzeugt wird. Diese wird, wie in Figur 2c dargestellt, mit den vorhandenen Strukturelementen verknüpft. Dadurch entsteht eine neue Konfiguration nach dem ersten Iterationsschritt mit einer neuen Abstandsverletzung in Form der Fehlerfigur 12. Die Fehlerfigur 12 wird in gleicher Weise wie vorstehend beschrieben durch Überlagerung der Korrekturfigur 13 modifiziert (Figur 2d). Wie in Figur 2e dargestellt, entsteht eine neue Konfiguration nach diesem zweiten Iterationsschritt mit einer neuen Abstandsverletzung in Form der Fehlerfigur 14. Durch erneute Überlagerung einer entsprechenden Korrekturfigur entsteht die fertigbare Konfiguration ohne Abstandsverletzungen nach drei Iterationsschritten, wie in Figur 2f dargestellt.

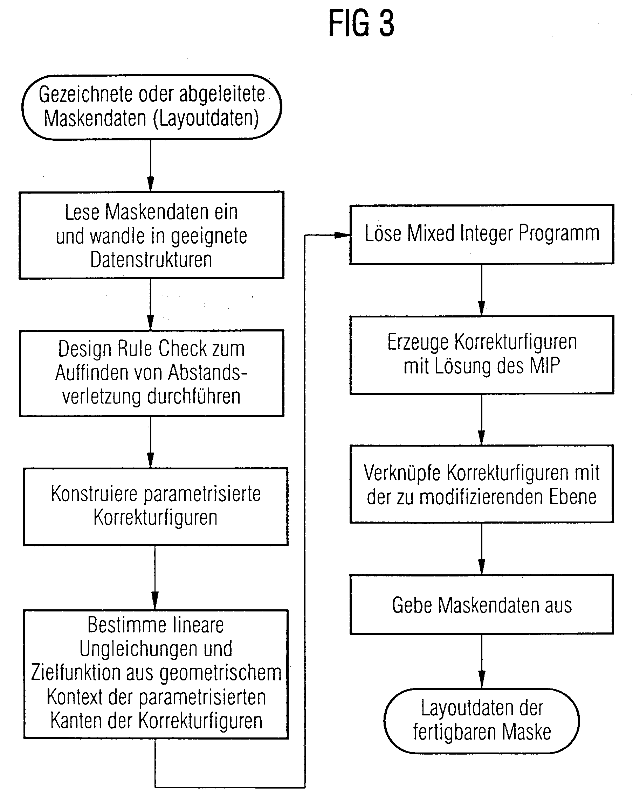

In dem Ausführungsbeispiel nach Figur 3 werden Generierungsfehler durch parametrisierte Korrekturfiguren beseitigt. Für die in diesem Beispiel orthogonalen Kanten der Korrekturfiguren werden durch geometrische Operationen Bedingungen in der Form linearer Ungleichungen aufgestellt, die mögliche Lagen der Kanten beschreiben. Beispielsweise ist die Ausgangsposition jeder einzelnen Kante in einem gewissen Bereich frei wählbar, die Bedingungen zwischen den Kanten sind jedoch durch die Ungleichungen gegeben.

Ähnlich wie im Beispiel nach Figur 1 werden die Layoutdaten erzeugt und eingelesen. Nach der Überprüfung, ob die geometrischen Design-Anforderungen für die einzelnen Strukturelemente erfüllt sind, werden im Fehlerfall parametrisierte Korrekturfiguren erzeugt. Diese werden zunächst derart erzeugt, daß die Kanten der Korrekturfiguren parametrisiert sind. Aus dem geometrischen Kontext der parametrisierten Kanten werden die linearen Ungleichungen für die Kanten der Korrekturfiguren aufgestellt, die potentielle Lagen der Kanten beschreiben. Außerdem wird ein Optimierungskriterium bzw. eine Zielfunktion bezüglich den geometrischen Anforderungen der Korrekturfiguren aufgestellt. Mit Hilfe eines mathematischen Optimierungsverfahrens, z.B. eines sogenannten Mixed-Integer-Programming-Verfahrens, werden Lagen der Kanten der Korrekturfiguren bestimmt, die die aufgestellten Ungleichungen und das Optimierungskriterium erfüllen. Die Korrekturfiguren sind damit durch die bestimmten Lagen der Kanten festgelegt. Mit der Lösung des Mixed-Integer-Programming-Verfahrens (MIP) werden Korrekturfiguren erzeugt. Diese werden, wie im vorherigen Ausführungsbeispiel beschrieben, mit der zu modifizierenden Ebene verknüpft.

Bei dem Optimierungskriterium handelt es sich beispielsweise um ein lineares Polynom in den zur Beschreibung möglicher Kantenlagen verwendeten Variablen. Beispielsweise gibt das Optimierungskriterium an, daß die Kanten der Korrekturfiguren, ausgehend von ihrer Ausgangslage, möglichst wenig verschoben werden. Ein anderes Optimierungskriterium gibt beispielsweise an, daß die Flächen der Korrekturfiguren möglichst klein sind. Auf diese Art lassen sich unterschiedliche Varianten eines Optimierungskriteriums erstellen, so daß unterschiedliche geometrische Anordnungen der Korrekturfiguren optimiert werden können.

Hierzu können beispielsweise bekannte Verfahren zur Layout-Kompaktierung eingesetzt werden (wie beispielsweise aus Kedem et al., "Graph-Optimization Techniques for IC Layout and Compaction", IEEE Transactions on Computer-Aided Design, Vol. CAD-3, No. 1, Jan. 1984). Das Optimierungskriterium kann ebenso wie die Ungleichungen verschiedenen technologischen und designtechnischen Randbedingungen angepaßt werden.

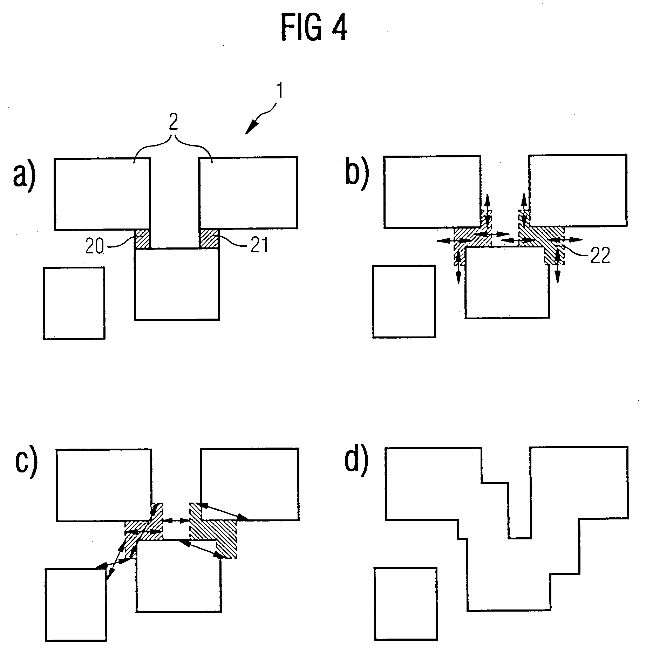

Figur 4a zeigt eine Konfiguration eines Maskenlayouts 1 mit Strukturelementen 2 mit Abstandsverletzungen in Form der Fehlerfiguren 20 und 21. Wie in Figur 4b dargestellt, werden Korrekturfiguren 22 mit parametrisierten Kanten erzeugt. Dabei ist die Position jeder der Kanten in einem gewissen Bereich frei wählbar, die Bedingungen zwischen den Kanten sind durch die aufgestellten Ungleichungen gegeben. In Figur 4c sind exemplarische Beziehungen zwischen den Kanten zur Bestimmung der Ungleichungen und der Zielfunktion dargestellt. Durch die Anwendung des mathematischen Optimierungsverfahrens werden die einzelnen Korrekturfiguren derart bestimmt, daß keine Abstandsverletzung mehr auftritt, wobei hier auch sekundäre Weitenverletzungen vermieden werden. In Figur 4d ist eine fertigbare Konfiguration ohne Abstandsverletzungen gezeigt. Da die jeweiligen Korrekturfiguren durch gezielte Parametrisierung erzeugt werden, kann unter Umständen eine höhere Genauigkeit im Vergleich zum iterativen Verfahren erzielt werden.

## Patentansprüche

1. Verfahren zur Herstellung von Masken für die Fertigung von Halbleiterstrukturen,
wobei das Verfahren mittels einer Datenverarbeitungseinrichtung durchgeführt wird und die folgenden Schritte umfasst:
- es werden Layoutdaten erzeugt, die Informationen zum Festlegen eines Maskenlayouts (1) für eine herzustellende Maske enthalten, wobei das Maskenlayout (1) geometrische Strukturelemente aufweist,
- es werden geometrische Design-Anforderungen für einzelne Strukturelemente (2) der Strukturelemente und für die Anordnung dieser einzelnen Strukturelemente (2) im Maskenlayout (1) festgelegt,
- es werden die Layoutdaten dahingehend überprüft, ob die geometrischen Design-Anforderungen für die einzelnen Strukturelemente (2) und für deren Anordnung im Maskenlayout (1) erfüllt sind,
- im Falle der Verletzung von Design-Anforderungen werden die entsprechenden Fehlerorte (10, 20) im Maskenlayout (1) anhand der Layoutdaten lokalisiert,
- es werden weitere Layoutdaten erzeugt, die Information zum Festlegen von Korrekturfiguren (11, 22) zur Korrektur der jeweiligen Fehlerorte (10, 20) enthalten,
- es werden die Layoutdaten mit den weiteren Layoutdaten verknüpft, so daß die Layoutdaten modifiziert werden.

2. Verfahren nach Anspruch 1,
**dadurch gekennzeichnet, daß**
die weiteren Layoutdaten durch Modifikation der Layoutdaten der jeweiligen Fehlerorte (10, 20) erzeugt werden.

3. Verfahren nach einem der Ansprüche 1 oder 2,
**dadurch gekennzeichnet, daß**
Layoutdaten für eine oder mehrere Maskenebenen erzeugt werden und das Verfahren für jede der Maskenebenen durchgeführt wird.

4. Verfahren nach einem der Ansprüche 1 bis 3,
**dadurch gekennzeichnet, daß**
die Schritte der Überprüfung der Layoutdaten, der Lokalisierung der Fehlerorte (10, 20), der Erzeugung der weiteren Layoutdaten und der Verknüpfung der Layoutdaten mit den weiteren Layoutdaten solange nacheinander durchgeführt werden, bis keine Design-Anforderungen mehr verletzt werden.

5. Verfahren nach einem der Ansprüche 1 bis 3, **dadurch gekennzeichnet, daß**
- die weiteren Layoutdaten derart erzeugt werden, daß die Kanten der Korrekturfiguren (22) parametrisiert sind,
- aus dem geometrischen Kontext der parametrisierten Kanten Ungleichungen für die Kanten der Korrekturfiguren (22) aufgestellt werden, die potentielle Lagen der Kanten beschreiben,
- ein Optimierungskriterium bezüglich den geometrischen Anforderungen der Korrekturfiguren (22) aufgestellt wird,
- ein mathematisches Optimierungsverfahren angewandt wird zur Bestimmung der jeweiligen Lagen der Kanten, so daß jeweils die aufgestellten Ungleichungen und das Optimierungskriterium erfüllt sind,
- die Korrekturfiguren (22) durch die bestimmten Lagen der Kanten festgelegt sind.

6. Verfahren nach Anspruch 5,
**dadurch gekennzeichnet, daß**
als mathematisches Optimierungsverfahren ein Mixed-Integer-Programming-Verfahren verwendet wird.

7. Verfahren nach einem der Ansprüche 1 bis 6,
**dadurch gekennzeichnet, daß**
die Layoutdaten mit den weiteren Layoutdaten additiv oder subtraktiv verknüpft werden.

8. Verfahren nach einem der Ansprüche 1 bis 7,
**dadurch gekennzeichnet, daß**
die Layoutdaten und die jeweils zugehörigen weiteren Layoutdaten in einer Datenbibliothek gespeichert werden.

9. Verfahren nach einem der Ansprüche 1 bis 8,
**dadurch gekennzeichnet, daß**
die Layoutdaten eine hierarchische Struktur aufweisen und die Layoutdaten anhand des Verfahrens nacheinander gemäß ihrer hierarchischen Struktur unter Berücksichtigung des jeweiligen geometrischen Kontexts modifiziert werden.

10. Verfahren nach einem der Ansprüche 1 bis 9,
**dadurch gekennzeichnet, daß**
die Maske zur Fertigung von Hilfsstrukturen einer integrierten Schaltung dient, die in der integrierten Schaltung elektrisch nicht wirksam sind.

## Claims

1. A method of producing masks for the manufacture of semiconductor structures,
the method being carried out by means of a data processing device and comprising the following steps:
- generating layout data comprising information for specifying a mask layout (1) for a mask to be produced, the mask layout (1) comprising geometrical structural elements,
- specifying geometrical design-related requirements for individual structural elements (2) among the structural elements and for the arrangement of said individual structural elements (2) in the mask layout (1),
- checking the layout data to the effect as to whether the geometrical design-related requirements are met for the individual structural elements (2) and for their arrangement in the mask layout (1),
- in case of violating design-related requirements, localizing the.corresponding error locations (10, 20) in the mask layout (1) on the basis of the layout data,
- generating further layout data comprising information for specifying correction figures (11, 22) for correcting the respective error locations (10, 20),
- combining the layout data with the further layout data, so that the layout data are modified.

2. The method according to claim 1,
**characterized in that**
the further layout data are generated by modification of the layout data of the respective error locations (10, 20).

3. The method according to any of the claims 1 or 2,
**characterized in that**
layout data are generated for one or more mask layers and the method is carried out for each of the mask layers.

4. The method according to any of the claims 1 to 3,
**characterized in that**
the steps of checking the layout data, localizing the error locations (10, 20), generating the further layout data and combining the layout data with the further layout data are carried out one by one until there are no violated design-related requirements.

5. The method according to any of the claims 1 to 3,
**characterized in that**
- the further layout data are generated such that the edges of the correction figures (22) are parameterized,
- inequations are established for the edges of the correction figures (22) from the geometrical context of the parameterized edges, said inequations describing the potential positions of the edges,
- an optimization criterion with respect to the geometrical requirements of the correction figures (22) is established,
- a mathematical optimization method is applied for the determination of the respective positions of the edges, so that the established inequations and the optimization criterion are met in each case,
- the correction figures (22) are defined by the determined positions of the edges.

6. The method according to claim 5,
**characterized in that**
the employed mathematical optimization method is a Mixed Integer Programming method.

7. The method according to any of the claims 1 to 6,
**characterized in that**
the layout data are combined with the further layout data in an additive or subtractive manner.

8. The method according to any of the claims 1 to 7,
**characterized in that**
the layout data and the respectively associated further layout data are stored in a data library.

9. The method according to any of the claims 1 to 8,
**characterized in that**
the layout data have a hierarchical structure and the layout data are modified on the basis of the method one by one according to their hierarchical structure in consideration of the respective geometrical context.

10. The method according to any of the claims 1 to 9,
**characterized in that**
the mask serves for manufacturing auxiliary structures of an
integrated circuit which do not have any electrical effect in the integrated circuit.

## Revendications

1. Procédé de fabrication de masques pour la production de structures semiconductrices,
sachant que le procédé est exécuté au moyen d'un dispositif de traitement de données et comprend les étapes suivantes :
- des données de layout qui contiennent des informations destinées à définir un layout de masque (1) pour un masque à fabriquer sont générées, sachant que le layout de masque (1) présente des éléments de structure géométriques,
- des exigences de design géométriques pour des éléments de structure (2) individuels des éléments de structure et pour la disposition de ces éléments de structure (2) individuels dans le layout de masque (1) sont définies,
- les données de layout sont vérifiées de façon à savoir si les exigences de design géométriques pour les éléments de structure (2) individuels et pour leur disposition dans le layout de masque (1) sont remplies,
- en cas d'enfreinte à des exigences de design, les endroits de défaut (10, 20) correspondants dans le masque de layout (1) sont localisés à l'aide des données de layout,
- des données de layout supplémentaires qui contiennent des informations destinées à définir des figures de correction (11, 22) pour la correction des endroits de défaut (10, 20) respectifs sont générées,
- les données de layout sont reliées aux données de layout supplémentaires de sorte que les données de layout soient modifiées.

2. Procédé selon la revendication 1,
**caractérisé en ce que**
les données de layout supplémentaires sont générées par modification des données de layout des endroits de défaut (10, 20) respectifs.

3. Procédé selon l'une des revendications 1 ou 2,
**caractérisé en ce que**
des données de layout sont générées pour un ou plusieurs plans de masque et le procédé est exécuté pour chacun des plans de masque.

4. Procédé selon l'une des revendications 1 à 3,
**caractérisé en ce que**
les étapes de vérification des données de layout, de localisation des endroits de défaut (10, 20), de génération des données de layout supplémentaires et de liaison des données de layout aux données de layout supplémentaires sont exécutées les unes après les autres jusqu'à ce que plus aucune exigence de design ne soit enfreinte.

5. Procédé selon l'une des revendications 1 à 3,
**caractérisé en ce que**
- les données de layout supplémentaires sont générées de telle façon que les bords des figures de correction (22) soient paramétrisés,
- des inégalités pour les bords des figures de correction (22), qui décrivent des emplacements potentiels des bords, sont établies à partir du contexte géométrique des bords paramétrisés,
- un critère d'optimisation relatif aux exigences géométriques des figures de correction (22) est établi,
- un procédé d'optimisation mathématique est appliqué pour déterminer les emplacements respectifs des bords, de telle sorte que respectivement les inégalités établies et le critère d'optimisation soient remplis,
- les figures de correction (22) sont définies par les emplacements déterminés des bords.

6. Procédé selon la revendication 5,
**caractérisé en ce que**
un procédé de programmation linéaire mixte est utilisé comme procédé d'optimisation mathématique.

7. Procédé selon l'une des revendications 1 à 6,
**caractérisé en ce que**
les données de layout sont reliées de manière additive ou soustractive aux données de layout supplémentaires.

8. Procédé selon l'une des revendications 1 à 7,
**caractérisé en ce que**
les données de layout et les données de layout supplémentaires afférentes respectivement sont enregistrées dans une bibliothèque de données.

9. Procédé selon l'une des revendications 1 à 8,
**caractérisé en ce que**
les données de layout présentent une structure hiérarchique et les données de layout sont modifiées les unes après les autres à l'aide du procédé selon leur structure hiérarchique compte tenu du contexte géométrique respectif.

10. Procédé selon l'une des revendications 1 à 9,
**caractérisé en ce que**
le masque sert à la production de structures auxiliaires d'un circuit intégré qui ne sont pas effectives électriquement dans le circuit intégré.
